# EUROPÄISCHE PATENTANMELDUNG

(11) **EP 1 568 750 A2**
(43) Veröffentlichungstag der Anmeldung: **31.08.2005**
(21) Anmeldenummer: 05003139.2
(22) Anmeldetag: 15.02.2005
(51) Int. Cl.: C09K 11/06, H01L 51/30

(54) **Verformbare elektrolumineszierende Anordnung**

(30) Priorität: 27.02.2004 DE 102004010145
(71) Anmelder: H.C. Starck GmbH, 38642 Goslar (DE)
(72) Erfinder: Guntermann, Udo, 47800 Krefeld (DE); Jonas, Friedrich, Dr., 52066 Aachen (DE)
(74) Vertreter: Bramer-Weger, Elmar

(57) **Zusammenfassung**

Die vorliegende Erfindung betrifft verformbare elektrolumineszierende Anordnungen enthaltend wenigstens eine transparente Trägerfolie, wenigstens eine transparente Elektrode, wenigstens eine elektrolumineszierende Schicht, wenigstens eine Dielektrikaschicht und wenigstens eine Gegenelektrode, dadurch gekennzeichnet, dass sich auf der Gegenelektrode oder zwischen Dielektrikaschicht und Gegenelektrode eine leitfähige Elektrodenschicht befindet, die wenigstens ein leitfähiges Polymer enthält, oder die Gegenelektrode eine leitfähige Elektrodenschicht ist, die wenigstens ein leitfähiges Polymer enthält, sowie die Herstellung und Verwendung solcher verformbaren elektrolumineszierenden Anordnungen.

## Beschreibung

Die vorliegende Erfindung betrifft verformbare elektrolumineszierende Anordnungen, deren Herstellung und Verwendung.

Elektrolumineszierende Anordnungen, im Folgenden auch als EL-Anordnungen bezeichnet, auf Basis anorganischer Leuchtpigmente sind bekannt. Diese Anordnungen weisen in der Regel folgenden Aufbau auf:
1. Transparente Trägerfolie
2. Transparente Elektrode
3. Elektrolumineszierende Schicht
4. Dielektrikum
5. Gegenelektrode

Bei Anlegen einer Wechselspannung von 30-500 V und 10 bis 5000 Hz leuchtet die elektrolumineszierende Schicht. Das erzeugte Licht wird durch die transparente Elektrode aus der Anordnung abgestrahlt.

Das Aufbringen der einzelnen Schichten erfolgt im allgemeinen durch Siebdruck, wobei die einzelnen Schichten nach dem Druck getrocknet werden, bevor die nächste Schicht aufgedruckt wird.

In WO-A 03/37039 ist beschrieben, dass EL-Anordnungen bei Verwendung von verformbaren Polymeren als Trägerfolie, z.B. durch Tiefziehen thermisch verformt werden können.

Es hat sich aber in der Praxis gezeigt, dass bei starker Verformung die Gegenelektrode nach dem Verformen Risse aufweist, die bei Betrieb der EL-Anordnung nicht leuchten.

Es bestand daher die Aufgabe, EL-Anordnungen aufzufinden, die auch nach Verformung vollflächig leuchten. Eine weitere Aufgabe bestand somit darin EL-Anordnungen bereitzustellen, in denen die Bildung von Rissen in der Gegenelektrode bei der Verformung oder die Bildung von Fehlstellen durch andere Maßnahmen verhindert bzw. ausgeglichen werden kann.

Überraschenderweise wurde gefunden, dass das Auftreten von nicht leuchtenden Stellen in EL-Anordnungen, d.h. Fehlstellen verhindert werden kann, wenn entweder unter oder auf die Gegenelektrode eine weitere verformbare Elektrodenschicht auf Basis von organischen leitfähigen Polymeren aufgebracht wird oder als Gegenelektrode eine verformbare Elektrodenschicht auf Basis von organischen leitfähigen Polymeren eingesetzt wird.

Gegenstand der vorliegenden Erfindung ist daher eine elektrolumineszierende Anordnung enthaltend, wenigstens eine transparente Trägerfolie, wenigstens eine transparente Elektrode, wenigstens eine elektrolumineszierende Schicht, wenigstens eine Dielektrikaschicht und wenigstens eine Gegenelektrode, dadurch gekennzeichnet, dass sich auf der Gegenelektrode oder zwischen Dielektrikaschicht und Gegenelektrode eine leitfähige Elektrodenschicht befindet, die wenigstens ein leitfähiges Polymer enthält, oder die Gegenelektrode eine leitfähige Elektrodenschicht ist, die wenigstens ein leitfähiges Polymer enthält.

Leitfähige Polymere können im Rahmen der Erfindung bevorzugt gegebenenfalls substituierte Polythiophene, Polyaniline, Polyphenylene, Poly(p-phenylenvinylene) oder Polypyrrole sein. Die leitfähige Elektrodenschicht kann auch Mischungen aus zwei oder mehreren dieser leitfähigen Polymeren enthalten.

Besonders bevorzugte leitfähige Polymere sind gegebenenfalls substituierte Polythiophene enthaltend wiederkehrende Einheiten der allgemeinen Formel (I), 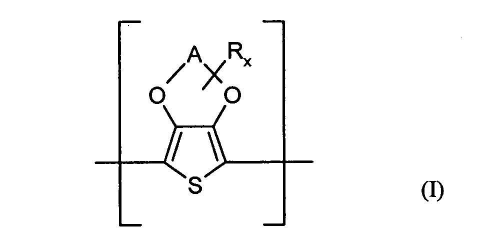 worin
- A: für einen gegebenenfalls substituierten C₁-C₅-Alkylenrest, bevorzugt für einen gegebenenfalls substituierten Ethylen- oder Propylenrest steht,
- R: für einen linearen oder verzweigten, gegebenenfalls substituierten C₁-C₁₈-Alkylrest, bevorzugt linearen oder verzweigten, gegebenenfalls substituierten C₁-C₁₄-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
- x: für eine ganze Zahl von 0 bis 8, bevorzugt für 0, 1 oder 2, besonders bevorzugt für 0 oder 1 steht und

für den Fall, dass mehrere Reste R an A gebunden sind, diese gleich oder unterschiedlich sein können.

Die allgemeine Formel (I) ist so zu verstehen, dass der Substituent R x-mal an den Alkylenrest A gebunden sein kann.

In bevorzugten Ausführungsformen sind Polythiophene enthaltend wiederkehrende Einheiten der allgemeinen Formel (I) solche enthaltend wiederkehrende Einheiten der allgemeinen Formel (Ia), 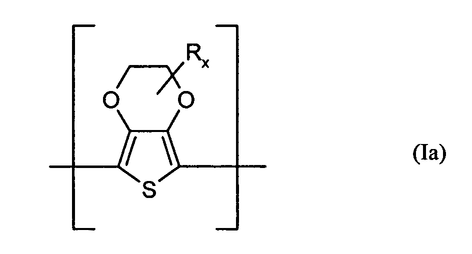 worin

R und x die oben genannte Bedeutung haben.

In weiteren bevorzugten Ausführungsformen sind Polythiophene enthaltend wiederkehrende Einheiten der allgemeinen Formel (I) solche enthaltend wiederkehrende Einheiten der allgemeinen Formel (Iaa)

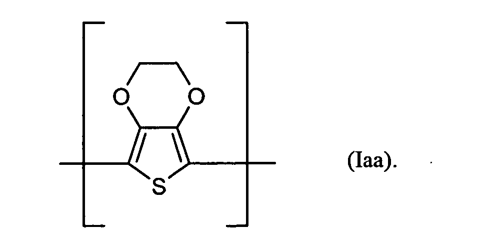

Unter dem Präfix Poly- ist im Rahmen der Erfindung zu verstehen, dass mehr als eine gleiche oder verschiedene wiederkehrende Einheit im Polymeren bzw. Polythiophen enthalten ist. Die Polythiophene enthalten insgesamt n wiederkehrende Einheiten der allgemeinen Formel (I), wobei n eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene enthaltend jeweils gleiche wiederkehrende Einheiten der allgemeinen Formel (I).

An den Endgruppen tragen die Polythiophene bevorzugt jeweils H.

In einer besonders bevorzugten Ausführungsform ist das Polythiophen enthaltend wiederkehrende Einheiten der allgemeinen Formel (I) Poly(3,4-ethylendioxythiophen); d.h. ein Homopolythiophen aus wiederkehrenden Einheiten der Formel (Iaa).

C₁-C₅-Alkylenreste A sind im Rahmen der Erfindung Methylen, Ethylen, n-Propylen, n-Butylen oder n-Pentylen. C₁-C₁₈-Alkyl steht im Rahmen der Erfindung für lineare oder verzweigte C₁-C₁₈-Alkylreste wie beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste wie beispielsweise Cyclopentyl, Cyclohexyl, Cycloheptyl, Cyclooctyl, Cyclononyl oder Cyclodecyl, C₅-C₁₄-Aryl für C₅-C₁₄-Arylreste wie beispielsweise Phenyl oder Naphthyl, und C₇-C₁₈-Aralkyl für C₇-C₁₈-Aralkylreste wie beispielsweise Benzyl, o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Als gegebenenfalls weitere Substituenten der C₁-C₅-Alkylenreste A kommen zahlreiche organische Gruppen in Frage, beispielsweise Alkyl-, Cycloalkyl-, Aryl-, Halogen-, Ether-, Thioether-, Disulfid-, Sulfoxid-, Sulfon-, Sulfonat-, Amino-, Aldehyd-, Keto-, Carbonsäureester-, Carbonsäure-, Carbonat-, Carboxylat-, Cyano-, Alkylsilan- und Alkoxysilangruppen sowie Carboxylamidgruppen.

Die leitfähigen Polymere bzw. Polythiophene können neutral oder kationisch sein. In bevorzugten Ausführungsformen sind sie kationisch, wobei sich "kationisch" nur auf die Ladungen bezieht, die auf der Polymer- bzw. Polythiophenhauptkette sitzen. Je nach Substituent an den Resten R können die Polymere bzw. Polythiophene positive und negative Ladungen in der Struktureinheit tragen, wobei sich die positiven Ladungen auf der Polymer- bzw. Polythiophenhauptkette und die negativen Ladungen gegebenenfalls an den durch Sulfonat- oder Carboxylatgruppen substituierten Resten R befinden. Dabei können die positiven Ladungen der Polymer- bzw. Polythiophenhauptkette zum Teil oder vollständig durch die gegebenenfalls vorhandenen anionischen Gruppen an den Resten R abgesättigt werden. Insgesamt betrachtet können die Polymere bzw. Polythiophene in diesen Fällen kationisch, neutral oder sogar anionisch sein. Dennoch werden sie im Rahmen der Erfindung alle als kationische Polymere bzw. Polythiophene betrachtet, da die positiven Ladungen auf der Polymer- bzw. Polythiophenhauptkette maßgeblich sind. Die positiven Ladungen sind in den Formeln nicht dargestellt, da ihre genaue Zahl und Position nicht einwandfrei feststellbar sind. Die Anzahl der positiven Ladungen beträgt jedoch mindestens 1 und höchstens n, wobei n die Gesamtanzahl aller wiederkehrenden Einheiten (gleicher oder unterschiedlicher) innerhalb des Polymers bzw. Polythiophens ist. Kationische Polymere bzw. Polythiophene werden im folgenden auch als Polykationen bezeichnet.

Zur Kompensation der positiven Ladung, soweit dies nicht bereits durch die gegebenenfalls Sulfonat- oder Carboxylat-substituierten und somit negativ geladenen Reste R erfolgt, benötigen die kationischen Polymere bzw. Polythiophene Anionen als Gegenionen.

Als Gegenionen kommen vorzugsweise polymere Anionen, im Folgenden auch als Polyanionen bezeichnet, in Frage.

Bevorzugt Gegenstand der vorliegenden Erfindung sind daher elektrolumineszierende Anordnungen worin die leitfähige Elektrodenschicht wenigstens ein leitfähiges Polymer als Polykation und wenigstens ein Polyanion enthält.

Als geeignete Polyanionen kommen beispielsweise Anionen polymerer Carbonsäuren, wie Polyacrylsäuren, Polymethacrylsäure oder Polymaleinsäuren, oder Anionen polymerer Sulfonsäuren, wie Polystyrolsulfonsäuren und Polyvinylsulfonsäuren in Frage. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein.

Besonders bevorzugt als polymeres Anion ist das Anion der Polystyrolsulfonsäure (PSS).

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f.).

Kationische Polythiophene, die zur Ladungskompensation Anionen als Gegenionen enthalten, werden in der Fachwelt auch oft als Polythiophen/(Poly-)Anion-Komplexe bezeichnet.

In der Schicht enthaltend wenigstens ein Polyanion und wenigstens ein Polykation kann das Polyanion als Gegenion fungieren. Es können jedoch auch zusätzliche Gegenionen in der Schicht enthalten sein. Bevorzugt dient jedoch in dieser Schicht das Polyanion als Gegenion.

Polyanion(en) und Polykation(en) können in der Schicht in einem Gewichtsverhältnis von 0,5:1 bis 50:1, bevorzugt von 1:1 bis 30:1, besonders bevorzugt 2:1 bis 20:1 enthalten sein. Das Gewicht der Polykationen entspricht hierbei der Einwaage der eingesetzten Monomere unter Annahme, dass bei der Polymerisation vollständiger Umsatz erfolgt.

In bevorzugten Ausführungsformen der vorliegenden Erfindung enthält die leitfähige Elektrodenschicht 3,4-Poly(ethylendioxythiophen) und Polystyrolsulfonat.

Die leitfähige Elektrodenschicht weist beispielsweise eine Dicke von 0,1 bis 20 µm, bevorzugt von 0,1 bis 5 µm auf. Angaben von Schichtdicken in dieser Anmeldung beziehen sich, sofern nichts anderes erwähnt, auf die Dicke der Schicht nach dem Trocknen.

Da es sich bei den erfindungsgemäßen elektrolumineszierenden Anordnungen bevorzugt um solche handelt, die verformbar sind, ist auch die Verwendung von transparenten Trägerfolien aus verformbaren Materialien bevorzugt. Geeignete transparente Trägerfolien sind beispielsweise Folien aus Kunststoffen. Besonders geeignete Kunststoffe sind: Polycarbonate, Polyester wie z.B. PET und PEN (Polyethylenterephthalat bzw. Polyethylennaphthalindicarboxylat), Copolycarbonate, Polysulfon, Polyethersulfon (PES), Polyimid, Polyethylen, Polypropylen oder cyclische Polyolefine bzw. cyclische Olefincopolymere (COC), Polyvinylchlorid, Polystyrol, hydrierte Styrolpolymere oder hydrierte Styrolcopolymere. Transparente Trägerfolien können beispielsweise Folien wie Polyesterfolien, PES-Folien der Firma Sumitomo oder Polycarbonatfolien der Firma Bayer AG (Makrofol®) sein.

Die transparente Trägerfolie weist beispielsweise eine Dicke von 10 bis 10000 µm, bevorzugt von 20 bis 500 µm auf.

Als Materialien für transparente Elektroden eignen sich beispielsweise
a) Metalloxide, z.B. Indium-Zinn-Oxid (ITO), Zinnoxid (NESA), dotiertes Zinnoxid, dotiertes Zinkoxid etc.,
b) semi-transparente Metallfilme, z.B. Au, Pt, Ag, Cu etc.,
c) semi-transparente, leitfähige Polymere, z.B. Polythiophene, Polyaniline, Polypyrrole etc..

Bevorzugte Materialien für die transparente Elektrode 1 sind semi-transparente, leitfähige Polymere, besonders bevorzugt ist Poly(3,4-Ethylendioxythiophen)/ Polystyrolsulfonat (PEDT/PSS).

Die transparente Elektrode weist beispielsweise eine Dicke von 0,1 bis 20 µm, bevorzugt von 0,2 bis 5 µm auf.

Als Leuchtpigmente für die elektrolumineszierende Schicht werden z.B. verkapselte Zinksulfidpigmente verwendet.

Die elektrolumineszierende Schicht weist beispielsweise eine Dicke von 30 bis 100 µm, bevorzugt von 40 bis 80 µm auf.

Als Dielektrikum wird z.B. Bariumtitanat verwendet.

Die Dielektrikaschicht weist beispielsweise eine Dicke von 50 bis 150 µm, bevorzugt von 60 bis 100 µm auf.

Als Gegenelektrode, sofern es sich bei dieser nicht um die bereits vorangehend beschriebene leitfähige Elektrodenschicht handelt, sind beispielsweise Leitsilberelektroden oder Elektroden auf Basis von leitfähigem Kohlenstoff geeignet.

Eine solche Gegenelektrode weist beispielsweise eine Dicke von 10 bis 50 µm, bevorzugt von 15 bis 30 µm auf.

In bevorzugten Ausführungsformen handelt es sich bei den erfindungsgemäßen elektroluminezierenden Anordnungen um solche, die verformt wurden.

Eine Verformung der erfindungsgemäßen elektrolumineszierenden Anordnungen kann beispielsweise durch Tiefziehen, Heißpressen oder Kaltpressen erfolgen. Bevorzugt erfolgt die Verformung thermisch, besonders bevorzugt durch Tiefziehen.

Das Tiefziehen kann in Abhängigkeit von den als Trägerfolie verwendeten Kunststoffen und der Dicke der Trägerfolie bei Temperaturen zwischen 50 und 350°C erfolgen.

Nach dem Verformen können die erfindungsgemäßen elektrolumineszierenden Anordnungen zur Erhöhung der mechanischen Stabilität noch - wie in WO-A 03/37039 beschrieben - mit Polymeren hinterspritzt werden. Geeignete Polymere für die Hinterspritzung sind z.B. Polycarbonate, Polycarbonat/Polybutylenterephthalat Blends

In bevorzugten Ausführungsformen der vorliegenden Erfindung handelt es sich bei den erfindungsgemäßen Anordnungen um solche enthaltend
1. eine transparente Trägerfolie 1
2. eine transparente Elektrode 2
3. eine elektrolumineszierende Schicht 3
4. eine Dielektrikaschicht 4
5. eine Gegenelektrode 5
6. eine leitfähige Elektrodenschicht 6
wobei die leitfähige Elektrodenschicht sich auf der Gegenelektrode befindet.

In weiteren bevorzugten Ausführungsformen der vorliegenden Erfindung handelt es sich bei den erfindungsgemäßen Anordnungen um solche enthaltend
1. eine transparente Trägerfolie 1
2. eine transparente Elektrode 2
3. eine elektrolumineszierende Schicht 3
4. eine Dielektrikaschicht 4
5. eine leitfähige Elektrodenschicht 6
6. eine Gegenelektrode 5
wobei die leitfähige Elektrodenschicht zwischen Dielektrikaschicht und Gegenelektrode befindet.

In weiteren bevorzugten Ausführungsformen der vorliegenden Erfindung handelt es sich bei den erfindungsgemäßen Anordnungen um solche enthaltend
1. eine transparente Trägerfolie 1
2. eine transparente Elektrode 2
3. eine elektrolumineszierende Schicht 3
4. eine Dielektrikaschicht 4
5. eine leitfähige Elektrodenschicht als Gegenelektrode 6

Überraschend können die erfindungsgemäßen elektrolumineszierenden Anordnungen einer Verformung unterzogen werden, ohne dass bei anschließendem Betrieb nicht-leuchtende Stellen auftreten. Die erfindungsgemäßen elektrolumineszierenden Anordnungen leuchten auch nach Verformung noch vollflächig.

Die erfindungsgemäßen elektrolumineszierenden Anordnungen können auf einfache Weise hergestellt werden, indem die einzelnen Schichten nacheinander aus der Gasphase oder aus Lösung bzw. Dispersion, bevorzugt jedoch möglichst viele Schichten aus Lösung bzw. Dispersion aufgebracht werden. Hierfür eignen sich beispielsweise Beschichtungsverfahren wie Siebdruck, Tiefdruck, Vorhanggießen und Rakelverfahren, deren Durchführung dem Fachmann bekannt ist. Bevorzugt werden möglichst viele der Schichten der erfindungsgemäßen elektrolumineszierenden Anordnungen mittels Siebdruck aufgebracht.

Für die Aufbringung der meisten Schichten stehen hierfür kommerziell erhältliche Siebdruckpasten zur Verfügung. Für die Aufbringung der elektrolumineszierenden Schicht und der Dielektrikaschicht können beispielsweise entsprechende Siebdruckpasten der Firmen Durel oder DuPont verwendet werden. Für die Aufbringung der Gegenelektrode, sofern es sich bei dieser nicht um die leitfähige Elektrodenschicht handelt, stehen kommerziell erhältliche Leitsilber- oder Graphitdruckpasten zur Verfügung (z.B. der Firmen Durel, Du Pont und Acheson) In den Ausführungsbeispielen sind geeignete Siebdruckpasten beispielhaft genannt. Für die Aufbringung einer transparenten Elektrode auf Basis eines leitfähigen Polymers eignet sich beispielsweise eine Siebdruckpaste enthaltend Poly(3,4-ethylendioxythiophen) und Polystyrolsulfonat die unter der Bezeichnung Baytron® S V2 (H.C. Starck GmbH) im Handel erhältlich ist. Bei der Aufbringung großflächiger Beschichtungen ab ca. 25 cm² kann es vorteilhaft sein zusätzlich noch so genannte Bus-Bars aus Leitsilber zwischen der transparenten Elektrode und der elektrolumineszierenden Schicht aufzudrucken. Hierzu stehen wiederum die kommerziell erhältlichen Leitsilberdruckpasten zur Verfügung.

Die leitfähige Elektrodenschicht wird ebenfalls bevorzugt aus Lösung oder Dispersion, bevorzugt im Siebdruckverfahren aufgebracht. Vorteilhafterweise bietet die Aufbringung mittels Siebdruck die Möglichkeit einer strukturierten Aufbringung Hierzu geeignete Siebdruckpasten sind beispielsweise in WO-A 99/34371 beschrieben.

Dies sind beispielsweise Siebdruckpasten mit einer Viskosität von 1 bis 200 dPas, bevorzugt 10 bis 100 dPas enthaltend eine Lösung oder Dispersion enthaltend wenigstens ein leitfähiges Polymer sowie gegebenenfalls wenigstens ein Polyanion, Bindemittel, Verdicker, Vernetzer, Füllstoffe und/oder Additive.

Als leitfähige Polymere eignen sich die vorangehend für die erfindungsgemäße elektrolumineszierende Anordnung bereits aufgeführten, insbesondere Poly(3,4-ethylendioxythiophen).

Bevorzugt enthalten die Siebdruckpasten Poly(3,4-ethylendioxythiophen)-Kationen und Polystyrolsulfonat-Anionen, wobei deren Gehalt in den erfindungsgemäßen Siebdruckpasten besonders bevorzugt größer gleich 2 Gew.-% ist. Deren Herstellung ist dem Fachmann bekannt und in WO-A 99/34371 beschrieben.

Zur Herstellung der Siebdruckpasten geeignete Lösungsmittel sind Wasser; mit Wasser mindestens teilweise mischbare Alkohole, wie Methanol, Ethanol, Isopropanol (2-Propanol), n-Propanol, n-Butanol, Glykole wie Ethylenglykol, Diethylenglycol, Propylenglykol, Glykolacetat, Glykolbutyrat, Methoxypropylacetat; Ketone wie Aceton, Methylethylketon, Methylisobutylketon, Diacetonalkohol; Amide wie N,N-Dimethylacetamid, N,N-Dimethylformamid, N-Methylpyrrolidon, N-Methyl-caprolactam.

Zur Einstellung der Viskosität können den Lösungen bzw. Dispersionen der leitfähigen Polymere ein oder mehrere Verdicker und/oder Bindemittel zugesetzt werden. Geeignete Verdicker bzw. Bindemittel sind z.B. Carrageenane, Verdicker auf Polyurethanbasis (z.B. Borchigel L 75 der Fa. Borchers), Polysaccharide, Polyvinylpyrrolidon, Polyethylenoxide, Agar Agar, Trabant, Gummi Arabicum, Alginate, Pektine, Guar-Mehl, Johannisbrotbaumkernmehl, Stärke, Dextrine, Gelatine, Casein, Carboxymethylcellulose u.a. Celluloseether, Hydroxyethylcellulose, Hydroxypropylcellulose, Polyurethane, Polyvinylacetate, Polyvinylbutyral, Polyacrylsäureester, Polymethacrylsäureester, Polystyrol, Polycarbonate, Polyacrylnitril, Polyvinylchlorid, Polybutadien, Polyisopren, Polyether, Polyester, Silicone, Styrol/Acrylsäureester-, Vinylacetat/Acrylsäureester- und Ethylen/VinylacetatCopolymerisate, Polyvinylalkohole, Polyamide, Polyurethane, Polyacrylate oder Polyolefine. Die Verdicker bzw. Bindemittel auf Basis organischer Monomere können als Homopolymere oder auch als Copolymere verwendet werden. Sie kommen als wasserlösliche oder in Wasser dispergierbare bzw. emulgierbare Polymere zum Einsatz. Zur Verbesserung der Wasserverträglichkeit hat es sich bewährt, partiell sulfonierte Polymere zu verwenden.

Bevorzugte organische Bindemittel sind Polyurethane, gegebenenfalls in Kombination mit anderen Bindemitteln.

Des Weiteren können den Siebdruckpasten Vernetzer wie z.B. Epoxysilane, wie 3-Glycidoxypropyltrialkoxysilan, und/oder Additive wie z.B. oberflächenaktive Verbindungen enthalten. Weiterhin können Alkoxysilanhydrolysate, z.B. auf Basis von Tetraethoxysilan, zur Erhöhung der Kratzfestigkeit der resultierenden Beschichtungen zugesetzt werden.

Auch können den Siebdruckpasten geeignete Additive zur Erhöhung der Leitfähigkeit der resultierenden leitfähigen Elektrodenschicht zugegeben werden, welche beispielsweise in EP-A 686 662 beschrieben sind. Hierfür eignen sich besonders ethergruppenhaltige Verbindungen, wie z.B. Tetrahydofuran, lactongruppenhaltige Verbindungen wie γ-Butyrolacton, γ-Valerolacton, amid- oder lactamgruppenhaltige Verbindungen wie Caprolactam, N-Methylcaprolactam, N,N-Dimethylacetamid, N-Methylacetamid, N,N-Dimethylformamid (DMF), N-Methylformamid, N-Methylformanilid, N-Methylpyrrolidon (NMP), N-Octylpyrrolidon, Pyrrolidon, Sulfone und Sulfoxide, wie z.B. Sulfolan (Tetramethylensulfon), Dimethylsulfoxid (DMSO), Zucker oder Zuckerderivate, wie z.B. Saccharose, Glucose, Fructose, Lactose, Zuckeralkohole wie z.B. Sorbit, Mannit, Furanderivate, wie z.B. 2- Furancarbonsäure, 3-Furancarbonsäure, und/oder Di- oder Polyalkohole, wie z.B. Ethylenglycol, Glycerin, Di- bzw. Triethylenglycol,. Besonders bevorzugt werden als leitfähigkeitserhöhende Additive Tetrahydrofuran, N-Methylformamid, N-Methylpyrrolidon, Dimethylsulfoxid oder Sorbit eingesetzt.

Den Siebdruckpasten können weiterhin Füllstoffe zur Erzielung der gewünschten Rheologie zugesetzt werden. Geeignete Füllstoffe sind Metalloxide wie Titandioxid, Zinkoxid, Aluminiumoxid; elektrisch leitfähige Metalloxide wie Indiumzinnoxid, Antimonzinnoxid; Metalle wie Silber Kupfer, Gold, Palladium, Platin; Siliziumdioxid, Silikate, Kieselsäuren, Polykieselsäuren, Zeolithe, Erdalkalicarbonate wie Calciumcarbonat, Schichtsilikate und Tonmineralien wie Montmorillonite oder Bentonite.

Die vorangehend aufgeführten Bindemittel, Verdicker, Vernetzer, Füllstoffe und/oder gegebenenfalls die Additive verbleiben ganz oder teilweise nach der Aufbringung und gegebenenfalls anschließenden Trocknung in der leitfähigen Elektrodenschicht. Daher können auch diese erfindungsgemäß ebenfalls Bestandteile der leitfähigen Elektrodenschicht in der erfindungsgemäßen elektrolumineszierenden Anordnung sein.

Weiterhin können den Siebdruckpasten vorangehend bereits aufgeführte Vernetzer sowie oberflächenaktive Verbindungen wie Verlaufsmittel, Tenside und/oder Antischaummittel zugesetzt werden.

Für die Aufbringung der leitfähigen Elektrodenschicht enthaltend wenigstens ein leitfähiges Polymer stehen ebenfalls kommerziell erhältliche Siebdruckpasten zur Verfügung. Beispielhaft für eine geeignete Siebdruckpaste sei hier die unter der Bezeichnung Baytron® S V2 (H.C. Starck GmbH) im Handel erhältliche, enthaltend Poly(3,4-ethylendioxythiophen)-Kationen und Polystyrolsulfonat, aufgeführt.

Die Siebdruckpasten können auf handelsüblichen Siebdruckmaschinen mit Polyester oder Metallsiebbespannungen verarbeitet werden. Die Verarbeitung mit Rotationssiebdruck oder Tampondruck ist ebenfalls möglich.

Nach dem Drucken werden die Beschichtungen getrocknet. Geeignete Trocknungstemperaturen liegen zwischen 0°C und 250°C. Bevorzugt wird bei erhöhter Temperatur, d.h. bei 50 bis 150°C getrocknet. Die Trocknungszeit liegt zwischen wenigen Sekunden und mehreren Stunden, bevorzugt beträgt sie 10 Sekunden bis 15 Minuten.

Eine erfindungsgemäße elektrolumineszierende Anordnung kann demnach beispielsweise hergestellt werden, indem auf eine transparente Trägerfolie eine transparente Elektrode aufgedampft oder mittels Siebdruck aufgedruckt wird. Nach Trocknung und gegebenenfalls nach Aufdrucken von Bus-Bars durch eine entsprechende Maske und erneuter Trocknung wird darauf die elektrolumineszierende Schicht aufgedruckt und getrocknet. Anschließend wird darauf die Dielektrikaschicht aufgedruckt und getrocknet. Auf die Dielektrikaschicht wird entweder die leitfähige Elektrodenschicht als Zwischenschicht oder als Gegenelektrode aufgedruckt und getrocknet, wobei auf die Zwischenschicht anschließend noch die Gegenelektrode aufgedruckt und ebenfalls getrocknet wird, oder aber zunächst eine Gegenelektrode, die kein leitfähiges Polymer enthält aufgedruckt und getrocknet, wobei auf diese anschließend eine leitfähige Elektrodenschicht aufgedruckt und getrocknet wird.

Die leitfähigen Elektrodenschichten 2, 5 und 6 können auch strukturiert aufgedruckt werden und sich dadurch vom Layout der anderen Schichten unterscheiden. Hierdurch wird z.B. eine einfache Darstellung von Symbolen wie Buchstaben und Zahlen möglich.

Die erfindungsgemäßen elektrolumineszierenden Anordnungen eignen sich hervorragend zur Herstellung verformter elektrolumineszierender Anordnungen, da nach der Verformung überraschend im anschließenden Betrieb keine nicht-leuchtenden Fehlstellen auftreten. Solche dreidimensional verformten erfindungsgemäßen elektrolumineszierenden Anordnungen eignen sich beispielsweise zur Herstellung leuchtender Tastaturen, z.B. für Mobil-Telefone, leuchtender Symbole, z.B. in Automobilen (Armaturenbrettern etc.), sowie leuchtenden Anzeigen in Haushaltsgeräten, wie z.B. Kaffeemaschinen, Staubsaugern etc.

### Beispiele

### Vergleichsbeispiel:

Auf eine 200 µm dicke Polycarbonatfolie 1 im DIN A 4 Format (Makrofol® DE 1-1, Bayer AG) werden im Siebdruckverfahren folgende Schichten unter Verwendung von kommerziell erhältlichen Siebdruckpasten (Siebdruckfarben) nacheinander aufgebracht.
1. Transparente Elektrode 2 unter Verwendung von Baytron® S V2 (Siebdruckpaste auf Basis von Poly(3,4-ethylendioxythiophen)/Polystyrolsulfonat/H.C. Starck GmbH,)
2. Elektrolumineszierende Schicht 3 unter Verwendung einer Druckpaste hergestellt durch Mischen von Durel Pigment 1IPHS001 (ZnS, grün lumineszierend) und Lösungsmittel/Bindemittelgemisch 1INR001 im Mischungsverhältnis 5,4 : 4,6)
3. Zwei Dielektrikaschichten 4 unter Verwendung der Durel Paste 1IND001 (Siebdruckpaste auf Basis von Bariumtitanat)
4. Leitsilbergegenelektrode 5 unter Verwendung der Durel Paste 1INC001 (Siebdruckpaste auf Basis von Silberflocken)

Die einzelnen Schichten werden jeweils 15 Minuten bei 130°C in einem Umluftofen getrocknet und auf Raumtemperatur (23°C) abgekühlt.

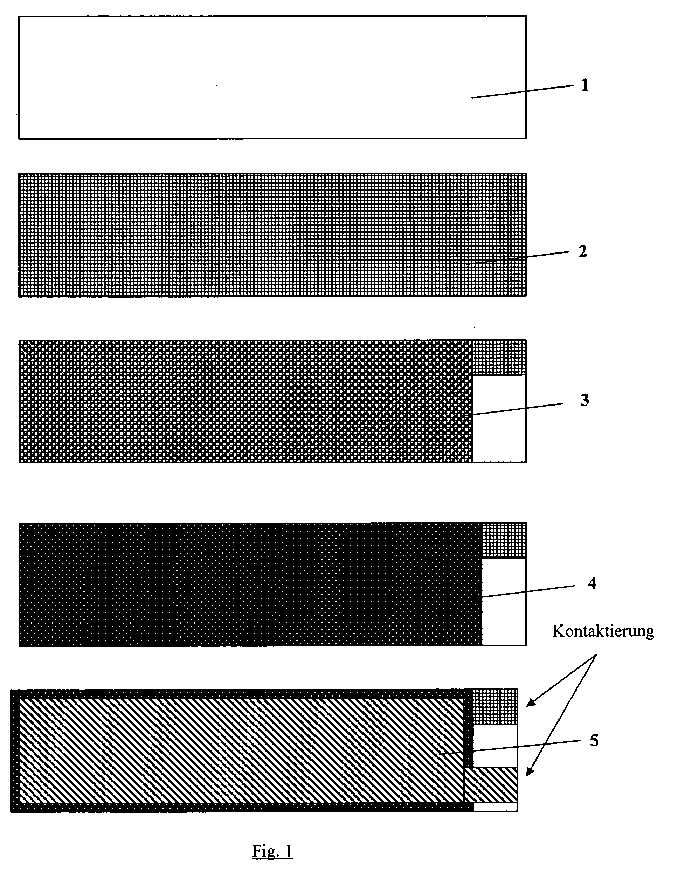

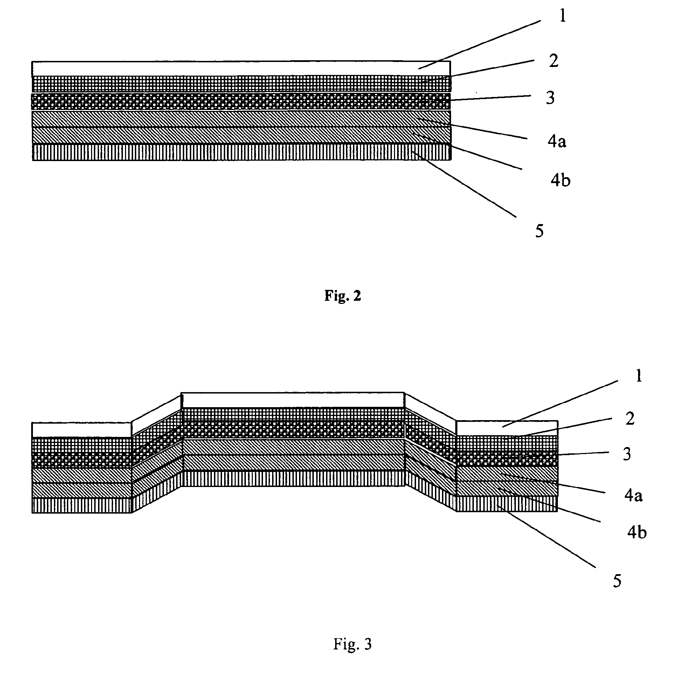

Der schematische Aufbau der elektrolumineszierenden Anordnung ist in Fig. 1 und Fig. 2 dargestellt. Darin bedeuten: 1 Transparente Trägerfolie, 2 Transparente Elektrode, 3 Elektrolumineszierende Schicht, 4a und 4b Dielektrikaschicht, 5 Leitsilbergegenelektrode

Anschließend wird die elektrolumineszierende Anordnung durch Tiefziehen bei 250°C verformt. Der Querschnitt der verformten elektrolumineszierenden Anordnung ist in Fig. 3 schematisch dargestellt.
Fig. 2: Elektrolumineszierende Anordnung nach Fig. 1 vor dem Verformen (Seitenansicht)
Fig. 3: Elektrolumineszierende Anordnung nach dem Verformen (Seitenansicht)

An die beiden Elektroden wird eine Wechselspannung von 100 V und 400 Hz angelegt. Nach dem Verformen leuchten die gestrichelt markierten Flächen nur teilweise.

### Beispiel 1 (erfindungsgemäß):

Auf die Gegenelektrode 5 einer gemäß Vergleichsbeispiel hergestellten elektrolumineszierenden Anordnung wird zusätzlich eine leitfähige Elektrodenschicht 6 unter Verwendung der Siebdruckpaste Baytron® S V2 (H.C.Starck GmbH) in einer Nassfilmdicke von ca. 15 µm aufgedruckt.

Die Schicht wird ebenfalls 15 Minuten bei 130°C getrocknet. Anschließend wird die erfindungsgemäße elektrolumineszierende Anordnung durch Tiefziehen bei 250°C mit der gleichen Form verformt, wie im Vergleichsbeispiel beschrieben. Nach dem Verformen werden die beiden Elektroden kontaktiert und eine Wechselspannung von 100 V und 400 Hz angelegt. Die ganze Elektrode leuchtet vollflächig. Nicht-leuchtende Stellen in Form von Rissen sind nicht erkennbar.

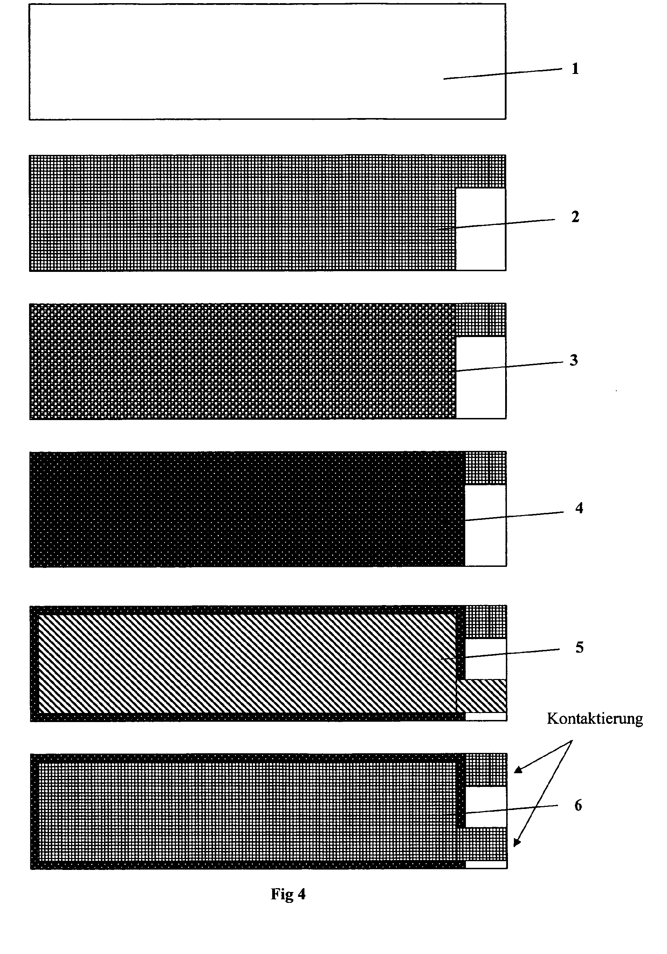

Der schematische Aufbau der elektrolumineszierenden Anordnung ist in Fig. 4 dargestellt. Darin bedeuten: 1 Transparente Trägerfolie, 2 Transparente Elektrode, 3 Elektrolumineszierende Schicht, 4a und 4b Dielektrikaschicht, 5 Leitsilbergegenelektrode, 6 leitfähige Elektrodenschicht

### Beispiel 2 (erfindungsgemäß):

Es wird eine elektrolumineszierende Anordnung gemäß Vergleichsbeispiel hergestellt, mit der Abweichung, dass anstelle der Leitsilbergegenelktrode 5 direkt die leitfähige Elektrodenschicht 6 unter Verwendung der Siebdruckpaste Baytron® S V2 (H.C.Starck GmbH) auf die zweite Dielektrikaschicht 4b aufgebracht wird. Auf eine weitere Gegenelektrode wird vollständig verzichtet.

Die Siebdruckpaste Baytron® S V2 wird wie in Beispiel 1 beschrieben in einer Nassfilmdicke von ca.15 µm auf die Dielektrikachicht 4b aufgedruckt und anschließend 15 Minuten bei 130°C getrocknet. Dann wird die erfindungsgemäße elektrolumineszierende Anordnung durch Tiefziehen bei 250°C mit der gleichen Form verformt, wie im Vergleichsbeispiel beschrieben. Nach dem Verformen werden die beiden Elektroden kontaktiert und eine Wechselspannung von 100 V und 400 Hz angelegt. Die ganze Elektrode leuchtet vollflächig. Nicht-leuchtende Stellen in Form von Rissen sind nicht erkennbar.

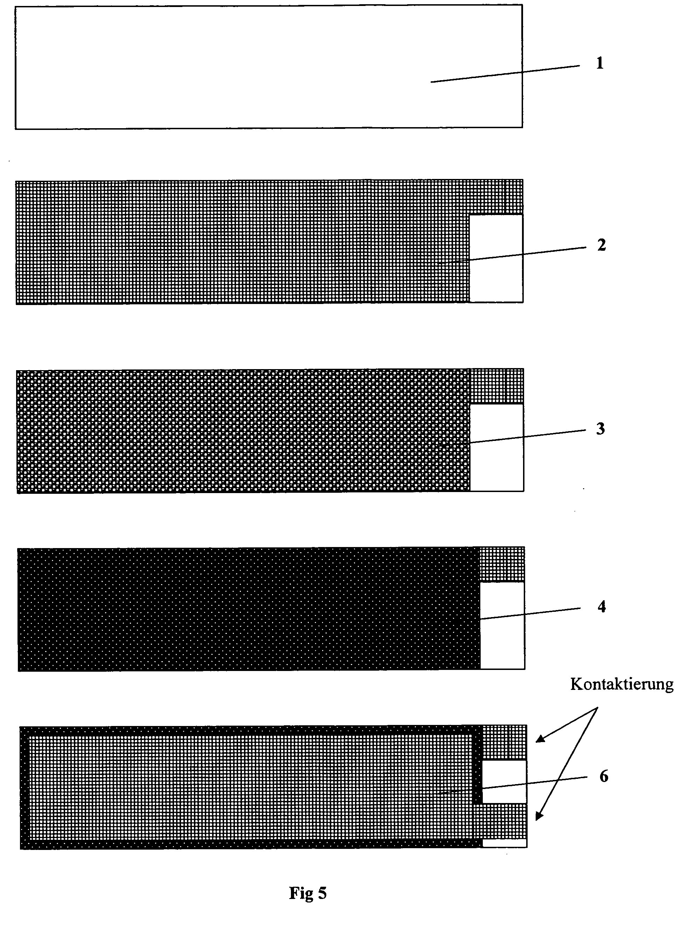

Der schematische Aufbau der elektrolumineszierenden Anordnung ist in Fig. 5 dargestellt. Darin bedeuten: 1 Transparente Trägerfolie, 2 Transparente Elektrode, 3 Elektrolumineszierende Schicht, 4a und 4b Dielektrikaschicht, 6 leitfähige Elektrodenschicht

### Beispiel 3 (erfindungsgemäß):

Auf die Dielektrikaschicht 4b einer gemäß Vergleichsbeispiel hergestellten elektrolumineszierenden Anordnung wird eine leitfähige Elektrodenschicht 6 unter Verwendung der Siebdruckpaste Baytron® S V2 (H.C.Starck GmbH) in einer Nassfilmdicke von ca. 15 µm aufgedruckt.

Die Schicht wird ebenfalls 15 Minuten bei 130°C getrocknet. Auf diese Schicht 6 wird dann die Leitsilberelektrode 5 aufgedruckt und getrocknet. Anschließend wird die erfindungsgemäße elektrolumineszierende Anordnung durch Tiefziehen bei 250°C mit der gleichen Form verformt, wie im Vergleichsbeispiel beschrieben. Nach dem Verformen werden die beiden Elektroden kontaktiert und eine Wechselspannung von 100 V und 400 Hz angelegt. Die ganze Elektrode leuchtet vollflächig. Nicht-leuchtende Stellen in Form von Rissen sind nicht erkennbar.

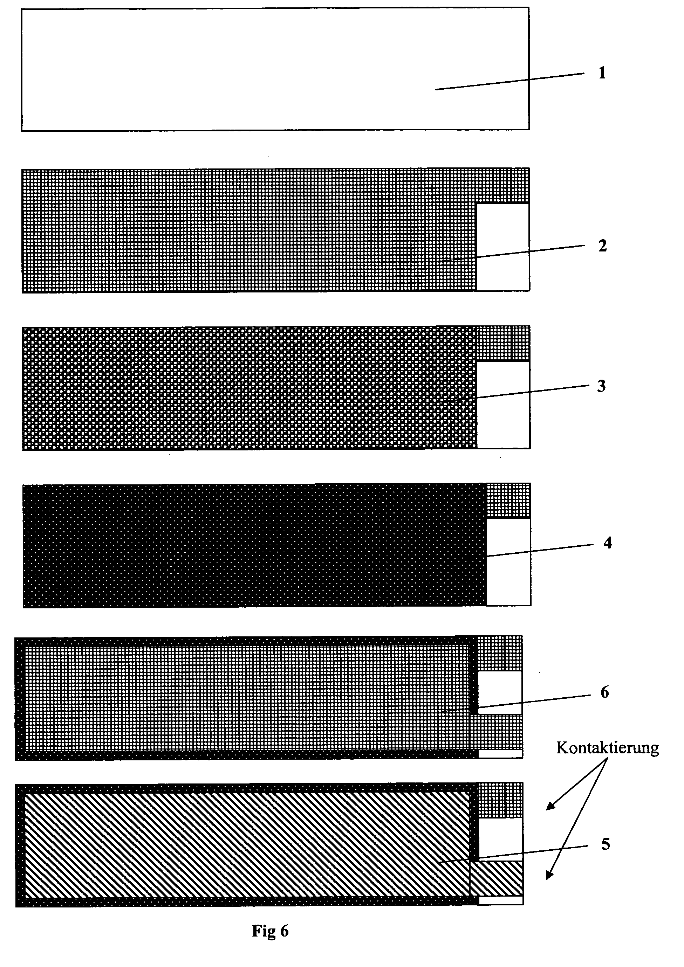

Der schematische Aufbau der elektrolumineszierenden Anordnung ist in Fig. 6 dargestellt. Darin bedeuten: 1 Transparente Trägerfolie, 2 Transparente Elektrode, 3 Elektrolumineszierende Schicht, 4a und 4b Dielektrikaschicht, 6 leitfähige Elektrodenschicht, 5 Leitsilbergegenelektrode,

## Patentansprüche

1. Elektrolumineszierende Anordnung enthaltend wenigstens eine transparente Trägerfolie, wenigstens eine transparente Elektrode, wenigstens eine elektrolumineszierende Schicht, wenigstens eine Dielektrikaschicht und wenigstens eine Gegenelektrode, **dadurch gekennzeichnet, dass** sich auf der Gegenelektrode oder zwischen Dielektrikaschicht und Gegenelektrode eine leitfähige Elektrodenschicht befindet, die wenigstens ein leitfähiges Polymer enthält, oder die Gegenelektrode eine leitfähige Elektrodenschicht ist, die wenigstens ein leitfähiges Polymer enthält.

2. Elektrolumineszierende Anordnung gemäß Anspruch 1, **dadurch gekennzeichnet, dass** wenigstens ein leitfähiges Polymer ein gegebenenfalls substituiertes Polythiophen, Polyanilin, Polyphenylen, Poly(p-phenylenvinylen) oder Polypyrrol ist.

3. Elektrolumineszierende Anordnung gemäß Anspruch 1 oder 2, **dadurch gekennzeichnet, dass** wenigstens ein leitfähiges Polymer ein gegebenenfalls substituiertes Polythiophen enthaltend wiederkehrende Einheiten der allgemeinen Formel (I) ist, 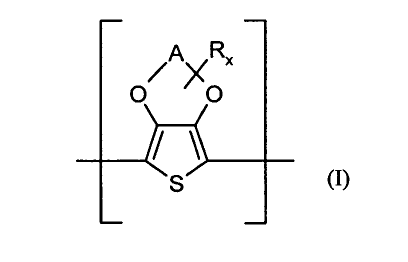 worin
A für einen gegebenenfalls substituierten C₁-C₅-Alkylenrest steht,
R für einen linearen oder verzweigten, gegebenenfalls substituierten C₁-C₁₈-Alkylrest, einen gegebenenfalls substituierten C₅-C₁₂-Cycloalkylrest, einen gegebenenfalls substituierten C₆-C₁₄-Arylrest, einen gegebenenfalls substituierten C₇-C₁₈-Aralkylrest, einen gegebenenfalls substituierten C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können.

4. Elektrolumineszierende Anordnung gemäß wenigstens einem der Ansprüche 1 bis 3, **dadurch gekennzeichnet, dass** wenigstens ein leitfähiges Polymer ein Polythiophen enthaltend wiederkehrende Einheiten der allgemeinen Formel (Iaa) ist

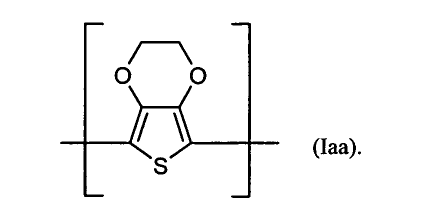

5. Elektrolumineszierende Anordnung gemäß wenigstens einem der Ansprüche 1 bis 4, **dadurch gekennzeichnet, dass** die leitfähige Elektrodenschicht wenigstens ein leitfähiges Polymer als Polykation und wenigstens ein Polyanion enthält.

6. Elektrolumineszierende Anordnung gemäß wenigstens einem der Ansprüche 1 bis 5, **dadurch gekennzeichnet, dass** die leitfähige Elektrodenschicht 3,4-Poly(ethylendioxythiophen) und Polystyrolsulfonat enthält.

7. Elektrolumineszierende Anordnung gemäß wenigstens einem der Ansprüche 1 bis 6, **dadurch gekennzeichnet, dass** sie verformbar ist.

8. Verfahren zur Herstellung einer elektrolumineszierenden Anordnung gemäß wenigstens einem der Ansprüche 1 bis 7, **dadurch gekennzeichnet, dass** die leitfähige Elektrodenschicht aus Lösung oder aus Dispersion aufgebracht wird.

9. Verfahren gemäß Anspruch 8, **dadurch gekennzeichnet, dass** die leitfähige Elektrodenschicht im Siebdruck aufgebracht wird.

10. Verwendung einer elektrolumineszierenden Anordnung gemäß wenigstens einem der Ansprüche 1 bis 7 zur Herstellung verformter elektrolumineszierender Anordnungen.

11. Verwendung einer elektrolumineszierenden Anordnung gemäß wenigstens einem der Ansprüche 1 bis 7 zur Herstellung thermisch verformter elektrolumineszierender Anordnungen.

12. Verwendung gemäß Anspruch 10 zur Herstellung von leuchtenden Tastaturen, Symbolen und Anzeigen.
